# FASCICULE DE BREVET EUROPEEN

(11) **EP 0 614 215 B1**
(45) Date de publication et mention de la délivrance du brevet: **23.07.1997**
(21) Numéro de dépôt: 94400442.3
(22) Date de dépôt: 02.03.1994
(51) Int. Cl.: H01L 21/308, H01L 21/027, G03F 7/38

(54) **Procédé de formation d'un contact métallique sur un relief d'un substrat semi-conducteur, incluant une étape de fluage d'une couche de résine photosensible**
Verfahren zur Herstellung eines Metallkontaktes auf einem Reliefmuster eines Halbleitersubstrates, mit einer Stufe zum plastischen Fliessen einer lichtempfindlichen Harzschicht
Process for forming a metal contact on a relief of a semicondactor substrate, including a step of flowing a photosensitive resin layer

(30) Priorité: 05.03.1993 FR 9302577
(43) Date de publication de la demande: 07.09.1994
(73) Titulaire: ALCATEL N.V., NL-1077 XX Amsterdam (NL)
(72) Inventeur: Poingt, Francis, F-91700 Ste Geneviève des Bois (FR); Gaumont-Goarin, Elisabeth, F-92120 Montrouge (FR); Le Gouezigou, Lionel, F-91530 Le Val Saint Germain (FR)
(74) Mandataire: Bourely, Paul

(56) Documents cités:
- EP-A- 0 497 644
- DE-A- 2 024 608
- IBM TECHNICAL DISCLOSURE BULLETIN., vol.22, no.12, Mai 1980, NEW YORK US pages 5321 - 5322 J.S. KRISTOFF ET AL. 'Process for etching self-aligned concentric via/contact holes'
- PATENT ABSTRACTS OF JAPAN vol. 12, no. 481 (E-694) 15 Décembre 1988 & JP-A-63 198 393 (NEC CORP.) 17 Aoüt 1988
- IBM TECHNICAL DISCLOSURE BULLETIN., vol.27, no.8, Janvier 1985, NEW YORK US pages 4871 - 4872 J.J. LAJZA ET AL. 'Terraced contact holes'
- PATENT ABSTRACTS OF JAPAN vol. 6, no. 67 (E-104) 28 Avril 1982 & JP-A-57 007 164 (FUJITSU LTD.) 14 Janvier 1982
- PATENT ABSTRACTS OF JAPAN vol. 9, no. 116 (P-357) 21 Mai 1985 & JP-A-60 002 948 (OKI DENKI KOGYO K.K.) 9 Janvier 1985

## Description

La présente invention concerne la formation et le positionnement d'un contact métallique sur un relief d'un substrat semi-conducteur par un procédé d'auto-alignement. Selon ce procédé:
a) on dépose sur le substrat semi-conducteur un film métallique, puis sur celle-ci un plot de résine photosensible,
b) on attaque le film métallique autour de la zone protégée par le plot de résine photosensible,
c) on fait fluer la résine photosensible autour de la zone protégée jusqu'à la faire venir au contact du substrat semi-conducteur,
d) on soumet le substrat semi-conducteur à une attaque tout autour de la zone protégée par le plot de résine photosensible.

Il a déjà été proposé dans le document JP-A-58/184763 un procédé de ce genre, dans lequel le fluage de la résine photosensible autour de la zone protégée par le plot de cette résine est obtenu par un traitement thermique à température assez élevée (vers 170°C) d'une durée notable (plusieurs dizaines de minutes). Toutefois la longueur de fluage de la résine est difficile à contrôler de façon précise, et la résine traitée a perdu sa photosensibilité. Il n'est donc pas possible de la soumettre à un nouveau traitement, par exemple pour pratiquer dans le plot une ouverture pour contact avec le substrat ou pour fenêtre d'irradiation. Par ailleurs, la résine traitée étant réticulée, on ne peut l'éliminer qu'à l'aide d'un solvant spécifique.

La présente invention a pour but un procédé de formation d'un contact métallique permettant de procurer un procédé d'auto-alignement d'un contact métallique sur un substrat de matériau semi-conducteur qui permette de délimiter avec plus de précision la zone protégée par la résine photosensible après fluage, cette délimitation étant obtenue, par une opération très rapide et à l'aide d'un solvant courant, et en laissant intactes les propriétés de photosensibilité de la résine, de façon à permettre un traitement ultérieur de celle-ci.

Le procédé de l'invention est caractérisé en ce que l'on effectue le fluage de la résine photosensible par passage de courte durée au contact de vapeurs d'un solvant de celle-ci.

Il répond en outre de préférence à au moins l'une des caractéristiques suivantes:
- On place pendant une courte durée le substrat revêtu du contact métallique et du plot de résine dans une enceinte sous atmosphère saturée de vapeur du solvant.
- On poursuit l'attaque du film métallique jusqu'à ce que le bord subsistant de ce film soit en retrait par rapport au bord du plot de résine photosensible.
- On réalise l'attaque du matériau semi-conducteur et donc l'auto-alignement d'un relief formé par la zone de ce matériau qui a été protégée de cette attaque par le plot de résine.
- On réalise ensuite une ouverture pour l'éclairement d'une photodiode ou pour la prise d'un contact avec le substrat de matériau semi-conducteur à travers la zone masquée par le plot de résine photosensible. Pour cela on dispose au-dessus de ce plot un masque percé par exemple d'une ouverture coïncidant avec celle qui doit être réalisée dans le film métallique, on soumet la résine photosensible dans cette ouverture à un rayonnement, et on élimine la résine irradiée, puis le métal sous-jacent.

Il est décrit ci-après, à titre d'exemple et en référence aux figures du dessin annexé, un procédé d'auto-alignement d'un contact métallique sur un substrat semi-conducteur selon l'invention.

Les figures 1A et 1B représentent respectivement en coupe par un plan vertical et en plan un plot de résine photosensible disposé sur un film métallique recouvrant un substrat semi-conducteur.

Les figures 2A et 2B représentent respectivement en coupe verticale et en plan le dispositif des figures 1a et 1b après attaque acide du film métallique, avec surgravage volontaire de façon que le bord du disque métallique subsistant sous le plot de résine photosensible soit en retrait par rapport au bord de ce dernier.

Les figures 3A et 3B représentent respectivement en coupe verticale et en plan le dispositif à plot de résine photosensible après fluage de celle-ci par traitement par un solvant.

Les figures 4A et 4B représentent respectivement en coupe verticale et en plan le dispositif à plot de résine photosensible après attaque du substrat semi-conducteur autour de la zone protégée par le plot de résine.

La figure 5 représente un masque destiné à être appliqué sur le dispositif des figures 4A et 4B afin d'y ménager une ouverture pour contact ou fenêtre d'éclairement.

Les figures 6A et 6B représentent en coupe verticale et en plan le dispositif après irradiation de la résine photosensible par un rayonnement lumineux, puis élimination de la résine irradiée.

Les figures 7A et 7B représentent en coupe verticale et en plan le dispositif après élimination de la couche métallique dans l'ouverture pour amenée d'un contact ou formation d'une fenêtre d'éclairement.

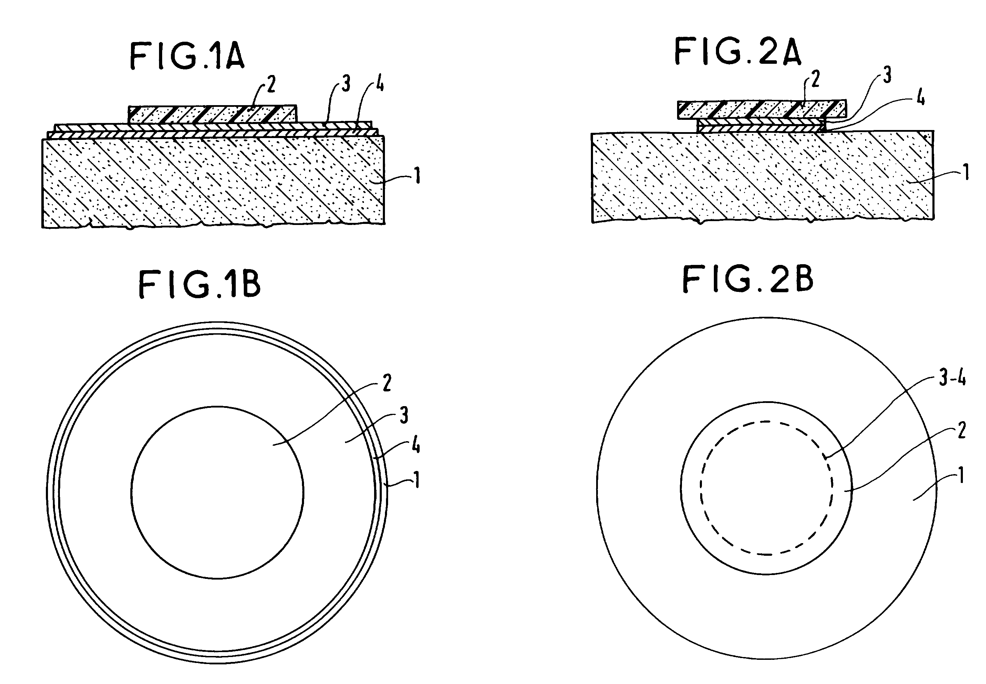

Dans les figures 1A et 1B, le substrat semi-conducteur 1 est recouvert en premier lieu du film de métallisation se composant d'une couche de titane 3 et d'une couche d'or 4. On dispose au-dessus du film de métallisation un plot de résine photosensible 2 de diamètre légèrement supérieur à celui du contact métallique désiré.

Les figures 2A et 2B représentent le même dispositif après attaque acide de la métallisation, avec surgravage volontaire de façon que le diamètre du contact métallique subsistant soit inférieur à celui du plot de résine photosensible, le bord du contact métallique étant alors en retrait par rapport à celui du plot de résine, de manière à faciliter l'opération suivante.

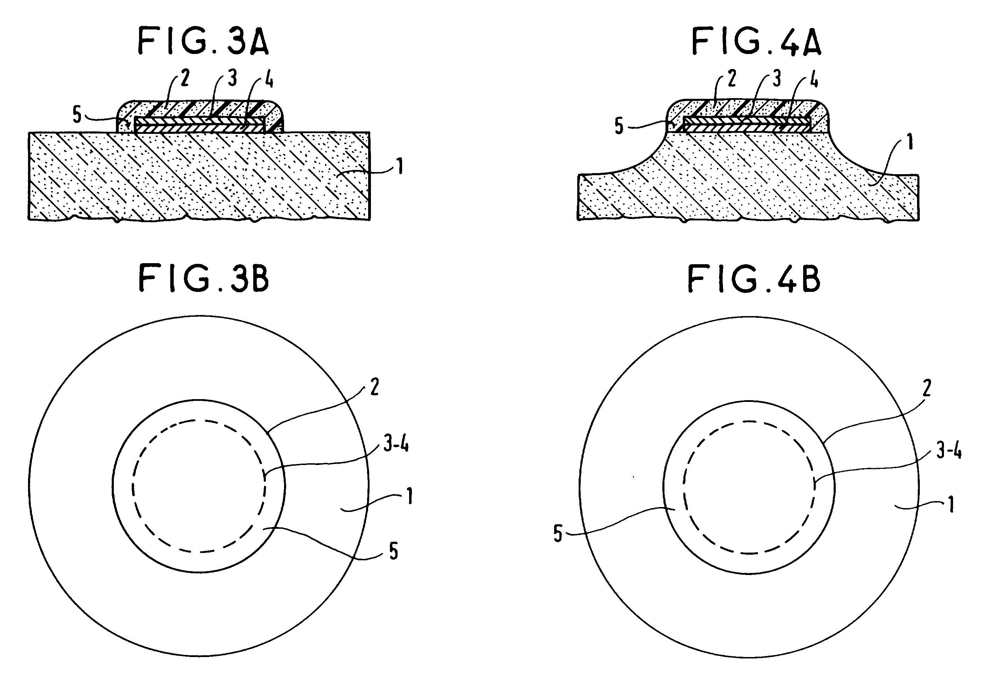

Les figures 3A et 3B représentent le dispositif après fluage de la résine par passage en enceinte fermée sous flux de vapeurs d'un solvant tel que l'acétone pendant quelques minutes. Le plot de résine photosensible (dont l'épaisseur a naturellement diminué) a flué sur ses bords pour former une couronne 5 au contact du substrat 1.

Comme représenté en figures 4A et 4B lors de l'attaque du substrat semi-conducteur par les mécanismes habituels, ce substrat n'est attaqué qu'autour des bords 5 du plot de résine photosensible.

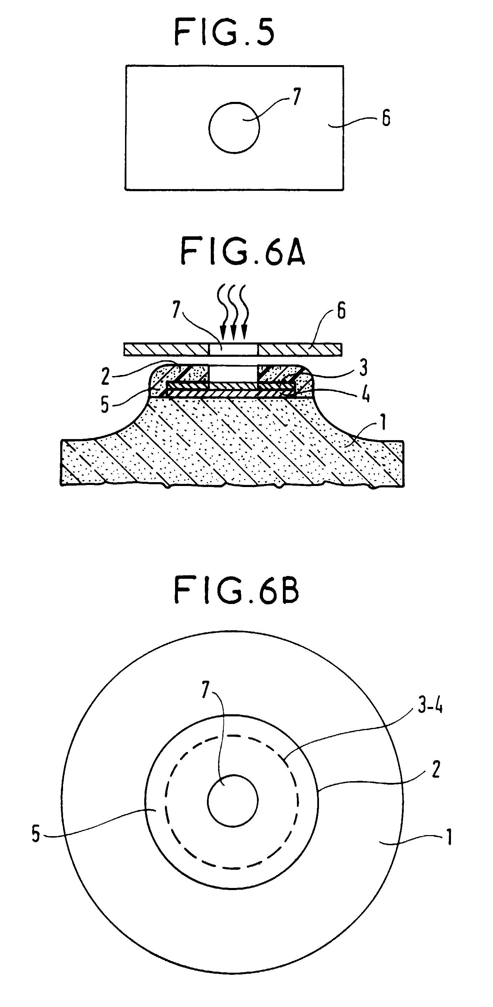

Lorsque l'on désire former un contact et/ou une fenêtre d'éclairage à travers le plot de résine photosensible, on dispose au-dessus de ce plot un second masque 6 muni d'une ouverture 7 (figure 5). On soumet alors la résine photosensible à un rayonnement lumineux à travers l'ouverture 7 du masque 6, (fig. 6A, 6B) puis on élimine la résine irradiée à l'aide d'un solvant ou par un autre procédé connu (plasma d'oxygène).

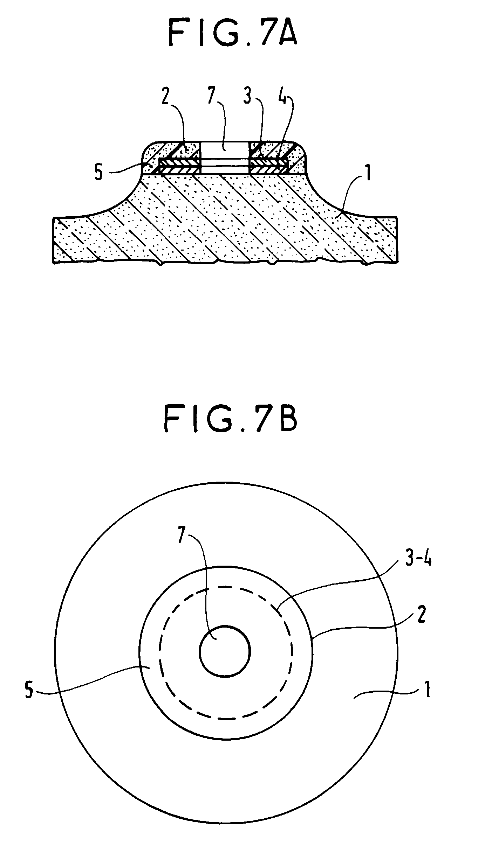

On procède ensuite à l'attaque acide de la métallisation du substrat semi-conducteur pour dégager la zone du contact et/ou la fenêtre d'éclairage 7 (notamment dans le cas de la formation d'un contact et d'une fenêtre d'éclairage pour photodiode " mésa" à éclairement par la face avant). On obtient ainsi le dispositif des figures 7A et 7B.

Bien que le procédé de l'invention ait été décrit en référence aux figures pour la réalisation d'un contact métallique circulaire, on comprendra qu'il convient tout aussi bien par la réalisation de contacts de formes géométriques différentes, notamment de contacts longitudinaux sur un ruban.

Le procédé de l'invention s'applique également à la fabrication de photodiodes à avalanche ou de diodes lasers, et de manière plus générale à celle de tout composant semi-conducteur (émetteur, détecteur ou récepteur) dont la fabrication requiert un auto-alignement.

## Revendications

1. Procédé de formation d'un contact métallique sur un relief d'un substrat semi-conducteur, dans lequel
a) on dépose sur le substrat semi-conducteur (1) un film métallique (3, 4), puis, sur une zone à protéger de celui-ci, un plot de résine photosensible (2),
b) on attaque le film métallique autour de la zone protégée par le plot de résine photosensible,
c) on fait fluer la résine photosensible autour de la zone protégée jusqu'à la faire venir au contact du substrat semi-conducteur, le fluage de la résine photosensible étant effectué par passage de courte durée au contact de vapeurs d'un solvant de celle-ci,
d) on soumet le substrat semi-conducteur à une attaque tout autour de la zone protégée par le plot de résine photosensible de manière à former ledit relief.

2. Procédé selon la revendication 1, caractérisé en ce que l'on dispose pendant une courte durée le contact métallique dans une enceinte sous atmosphère saturée de vapeur du solvant.

3. Procédé selon les revendications 1 ou 2, caractérisé en ce que l'on poursuit l'attaque du film métallique durant l'étape b) jusqu'à ce que le bord subsistant de ce film (3, 4) soit en retrait par rapport au bord du plot de résine photosensible (2).

4. Procédé selon l'une des revendications 1 à 3, caractérisé en ce que l'on réalise une ouverture dans le film métallique (3, 4) dans la zone protégée par le plot de résine photosensible en disposant au-dessus de celui-ci un masque (6) définissant l'ouverture (7) à réaliser, en soumettant la résine photosensible à un rayonnement à travers ce masque, et en effectuant un traitement d'ablation sélective pour éliminer la résine dans l'ouverture ainsi définie, puis en attaquant le métal sous-jacent dans cette ouverture.

## Patentansprüche

1. Verfahren zur Bildung eines metallischen Kontakts auf einem Relief eines Halbleitersubstrats,
a) wobei man auf dem Halbleitersubstrat (1) eine Metallschicht (3, 4) und dann auf einer zu schützenden Zone dieser Schicht einen Fleck eines lichtempfindlichen Harzes (2) aufbringt,
b) dann die Metallschicht um die durch den Fleck aus lichtempfindlichem Harz geschützte Zone herum abätzt,
c) dann das lichtempfindliche Harz um die geschützte Zone herum zerfließen läßt, bis es mit dem Halbleitersubstrat in Kontakt kommt, wobei das lichtempfindliche Harz kurzzeitig mit Dämpfen eines Lösungsmittels für dieses Harz in Kontakt gebracht und damit fließend gemacht wird,
d) dann das Halbleitersubstrat um die durch den Fleck aus lichtempfindlichem Harz geschützte Zone herum abätzt, so daß sich das Relief bildet.

2. Verfahren nach Anspruch 1, dadurch gekennzeichnet, daß während einer kurzen Dauer der metallische Kontakt in eine Kammer gebracht wird, in der eine gesättigte Atmosphäre des Dampfes des Lösungsmittels herrscht.

3. Verfahren nach den Ansprüchen 1 und 2, dadurch gekennzeichnet, daß das Abätzen der Metallschicht während des Schritts b) solange fortgesetzt wird, bis der verbleibende Rand dieser Schicht (3, 4) bezüglich des Rands des Flecks aus lichtempfindlichem Harz (2) zurückweicht.

4. Verfahren nach einem der Ansprüche 1 bis 3, dadurch gekennzeichnet, daß man eine Öffnung in der Metallschicht (3, 4) innerhalb der durch den Fleck aus lichtempfindlichem Harz geschützten Zone bildet, indem eine Maske (6) mit der zu bildenden Öffnung (7) auf den Fleck gelegt wird, dann das lichtempfindliche Harz einer Bestrahlung durch diese Maske hindurch ausgesetzt wird und dann das Harz selektiv abgetragen wird, um das Harz in der so definierten Öffnung zu entfernen, worauf das darunterliegende Metall in dieser Öffnung weggeätzt wird.

## Claims

1. A method of forming a metal contact on a projection on a semiconductor substrate, in which:
a) a metal film (3, 4) is deposited on the semiconductor substrate (1), and then a spot of photosensitive resin (2) is deposited on a zone of the substrate that is to be protected;
b) the metal film around the zone protected by the spot of photosensitive resin is etched;
c) the photosensitive resin is caused to flow around the protected zone so as to come into contact with the semiconductor substrate, the photosensitive resin being caused to flow by passing it for a short period of time in contact with vapor of a solvent for the resin; and
d) the semiconductor substrate is subjected to etching all around the zone protected by the spot of photosensitive resin, in such a manner as to form said projection.

2. A method according to claim 1, characterized in that the metal contact is placed for a short period of time in an enclosure under an atmosphere saturated with vapor of the solvent.

3. A method according to claim 1 or 2, characterized in that the etching of the metal film during step b is continued until the remaining edge of said film (3, 4) is set back relative to the edge of the spot of photosensitive resin (2).

4. A method according to any one of claims 1 to 3, characterized in that an opening is formed in the metal film (3, 4) in the zone protected by the spot of photosensitive resin by placing over the spot a mask (6) defining the opening (7) to be made, by subjecting the photosensitive resin to radiation through said mask, and by performing a selective ablation treatment to remove the resin in the opening defined in this way, and then by etching the metal underlying said opening.
